# EUROPÄISCHE PATENTSCHRIFT

(11) **EP 3 516 705 B1**
(45) Veröffentlichungstag und Bekanntmachung des Hinweises auf die Patenterteilung: **28.09.2022**
(21) Anmeldenummer: 17761219.9
(22) Anmeldetag: 24.08.2017
(51) Int. Cl.: H01L 31/18, H01L 21/02

(54) **VERFAHREN ZUM ANORDNEN MEHRERER SAATSUBSTRATE AN EINEM TRÄGERELEMENT UND TRÄGERELEMENT MIT SAATSUBSTRATEN**
METHOD FOR ARRANGING A PLURALITY OF SEED SUBSTRATES ON A CARRIER ELEMENT AND CARRIER ELEMENT HAVING SEED SUBSTRATES
PROCÉDÉ D'AGENCEMENT DE PLUSIEURS SUBSTRATS DE GERMINATION SUR UN ÉLÉMENT DE SUPPORT ET ÉLÉMENT DE SUPPORT COMPRENANT DES SUBSTRATS DE GERMINATION

(30) Priorität: 22.09.2016 DE 102016117912
(43) Veröffentlichungstag der Anmeldung: 31.07.2019
(73) Patentinhaber: Nexwafe GmbH, 79108 Freiburg (DE)
(72) Erfinder: REBER, Stefan, 79194 Gundelfingen (DE); SCHILLINGER, Kai, 79106 Freiburg (DE)
(74) Vertreter: LBP Lemcke, Brommer & Partner Patentanwälte mbB
(86) Internationale Anmeldenummer: PCT/EP2017/071368
(87) Internationale Veröffentlichungsnummer: WO 2018/054651

(56) Entgegenhaltungen:
- US-A1- 2004 206 444
- US-A1- 2014 370 650
- BRENDEL R: "REVIEW OF LAYER TRANSFER PROCESSES FOR CRYSTALLINE THIN-FILM SILICON SOLAR CELLS", JAPANESE JOURNAL OF APPLIED PHYSICS, JAPAN SOCIETY OF APPLIED PHYSICS, JP, Bd. 40, Nr. 7, PART 01, 1. Juli 2001 (2001-07-01), Seiten 4431-4439, XP001073140, ISSN: 0021-4922, DOI: 10.1143/JJAP.40.4431
- SCHMICH ET AL: "Silicon CVD deposition for low cost applications in photovoltaics", SURFACE AND COATINGS TECHNOLOGY, ELSEVIER BV, AMSTERDAM, NL, Bd. 201, Nr. 22-23, 9. August 2007 (2007-08-09), Seiten 9325-9329, XP022191985, ISSN: 0257-8972, DOI: 10.1016/J.SURFCOAT.2007.04.089

## Beschreibung

Die Erfindung betrifft ein Verfahren zum Anordnen mehrerer Saatsubstrate an einem Trägerelement sowie ein Trägerelement mit Saatsubstraten.

Für großflächige elektronische Bauteile wie beispielsweise großflächige Leuchtelemente (OLEDs) oder photovoltaische Solarzellen besteht ein Bedarf an kostengünstigen Halbleiterwafern mit hoher elektronischer Güte, da bei solchen Bauelementen die Materialkosten des Halbleiterwafers einen wesentlichen Anteil an den Kosten des Gesamtprodukts darstellen. Zur Herstellung von Halbleiterwafern sind Verfahren bekannt, wobei aus Siliziumblöcken ("lngots") mittels Sägeverfahren Halbleiterwafer hergestellt werden. Hierdurch lassen sich hochwertige, insbesondere einkristalline Halbleiterwafer herstellen. Die Herstellungskosten sind jedoch hoch, auch begründet durch den Materialverlust beim Zersägen der Siliziumblöcke.

Es wurden daher alternative Verfahren entwickelt, bei welchen eine Halbleiterschicht auf einem Saatsubstrat abgeschieden und anschließend von dem Trägersubstrat abgelöst wird. Die abgelöste Halbleiterschicht stellt somit den Halbleiterwafer zur Herstellung des elektronischen Bauelements dar.

Für solche Verfahren zur Herstellung einer Halbleiterschicht wurden verschiedene Optimierungen vorgenommen, so wurde in WO 2013/004851 A1 die Fläche potentieller parasitärer Abscheidungen während des Beschichtungsvorgangs minimiert.

Bei den vorbekannten Verfahren, bei welchen eine Halbleiterschicht auf einem Saatsubstrat abgeschieden und anschließend abgelöst wird, sind die Saatsubstrate während des Abscheidevorgangs an einem Trägerelement angeordnet.

Dieses flächige Trägerelement weist Halterungen auf, in welche die Saatsubstrate vor dem Aufbringen der Halbleiterschicht eingelegt werden. Nach Aufbringen der Halbleiterschicht werden die Saatsubstrate dem Trägerelement entnommen, um die Halbleiterschicht abzulösen.

Aus der US 2004/0206444 A1 ist ein Verfahren zur Herstellung und zur Übertragung von Halbleiterschichten bekannt, wobei auf einem Trägersubstrat zwischen einem, auf dem Trägersubstrat aufliegenden Ring, eine Trennschicht aufgebracht wird, auf welcher zunächst eine Keimschicht und anschließend eine weitere Halbleiterschicht epitaktisch aufgebracht wird.

Aus der US 2014/0370650 A1 ist ein Verfahren zur Herstellung von monolithischen Rückseitenkontakt-Solarzellen bekannt, wobei auf einem Saatsubstrat zunächst eine epitaktische Halbleiterschicht abgeschieden wird, welche abgelöst und anschließend einer Partitionierung zur Ausbildung von monolithischen Inseln unterzogen wird.

Der vorliegenden Erfindung liegt die Aufgabe zugrunde, das vorgenannte Trägerelement und dessen Verwendung zu verbessern.

Gelöst ist diese Aufgabe durch ein Verfahren gemäß Anspruch 1 und ein Trägerelement gemäß Anspruch 13. Vorteilhafte Ausgestaltungen des erfindungsgemäßen Verfahrens finden sich in den Ansprüchen 2 bis 12. Eine vorteilhafte Ausgestaltung des erfindungsgemäßen Trägerelementes findet sich in Anspruch 14.

Das erfindungsgemäße Verfahren ist bevorzugt zur Durchführung mittels des erfindungsgemäßen Trägerelementes, insbesondere einer bevorzugten Ausführungsform hiervon, ausgebildet. Das erfindungsgemäße Trägerelement ist bevorzugt zur Verwendung in dem erfindungsgemäßen Verfahren, insbesondere einer bevorzugten Ausführungsform hiervon, ausgebildet.

Die Erfindung ist in der Erkenntnis begründet, dass bei den bisherigen Herstellungsverfahren eine Halbleiterschicht, bei welcher eine Halbleiterschicht auf ein Halbleiter-Saatsubstrat aufgebracht und anschließend abgelöst wird, erhebliche Kosten und auch Fehlerstellen, an welchen eine Beschädigung oder ein Zerbrechen der Halbleiter-Saatsubstrate und/oder der Halbleiterschichten erfolgen kann, durch die Verwendung unterschiedlicher Trägerelemente für verschiedene Prozessschritte und das Anordnen und Abnehmen der Halbleiter-Saatsubstrate an den Trägerelementen zwischen den Prozessschritten besteht. Untersuchungen führten zu der Erkenntnis, dass eine dauerhafte Fixierung der Halbleiter-Saatsubstrate an dem Trägerelement während zumindest eines, vorzugsweise während einer Mehrzahl von Prozessschritten zu einer erheblichen Vereinfachung und Verringerung von Risikofaktoren führt. Ausgehend von dieser Erkenntnis besteht somit Bedarf an einer für die Prozessschritte dauerhaften Fixierung, welche jedoch wahlweise zur Erneuerung der Halbleiter-Saatsubstrate an dem Trägerelement gelöst werden kann.

Bei dem erfindungsgemäßen Verfahren werden mehrere Halbleiter-Saatsubstrate an einem Trägerelement angeordnet, um ein Aufbringen einer Halbleiterschicht auf die Saatsubstrate zu ermöglichen. Wesentlich ist, dass die Saatsubstrate auf das Trägerelement aufgelegt und mittels stofflicher Verbindung an dem Trägerelement angeordnet werden, wobei die stoffliche Verbindung zwischen Saatsubstrat und Trägerelement ein Halbleitermaterial umfassend ausgebildet wird, wobei die stoffliche Verbindung das Halbleitermaterial umfassend ausgebildet wird, welches zur Ausbildung der Halbleiterschicht verwendet wird, wobei die Saatsubstrate auf eine Oberfläche des Trägerelements aufgelegt werden und zumindest bereichsweise an seitlichen Stirnseiten der Saatsubstrate eine stoffliche Verbindung mit dem Trägerelement ausgebildet wird, und wobei ein Saatsubstrat mittels stofflicher Verbindung mit dem Trägerelement und mit einem benachbarten Saatsubstrat verbunden wird.

Die Anordnung der Halbleiter-Saatsubstrate mittels stofflicher Verbindung an dem Trägerelement weist folgende Vorteile auf:
- Die Trägerelemente müssen keine Einschub- oder Klemmelemente für die Saatsubstrate aufweisen und können somit kostengünstiger und robuster hergestellt werden. Darüber hinaus entfällt eine Abschattung der Saatsubstrate durch Einschub- oder Klemmelemente während des Beschichtungsvorgangs.
- Die Bruchgefahr der Saatsubstrate bei einem Wechsel der Trägerelemente zwischen einzelnen Prozessschritten wird vermieden.
- Es ergeben sich zusätzliche kostengünstige Verfahrensmöglichkeiten, wie beispielsweise eine Oberflächenbehandlung aller bereits auf das Trägerelement aufgebrachten Saatsubstrate.
- Die Anordnung der Saatsubstrate mittels stofflicher Verbindung an den Trägerelementen ermöglicht einen geringeren Abstand zwischen den Saatsubstraten, so dass für eine gegebene Fläche des Trägerelementes eine größere Ausbeute bei dem Erzeugen von Halbleiterschichten erzielt werden kann.
- Die stoffliche Verbindung führt zu einer mechanischen Stabilisierung der Saatsubstrate, so dass die Verwendung dünnerer Saatsubstrate im Vergleich mit vorbekannten Verfahren bei in Einschüben gelagerten oder mittels Klemmung gehaltenen Saatsubstraten möglich ist.
- Durch die Stabilisierung der Saatsubstrate mittels stofflicher Verbindung an dem Trägerelement kann die Anzahl von Herstellungszyklen, für welche die Saatsubstrate zur Herstellung von Halbleiterschichten verwendet werden, erhöht werden, da die Verwendung dünnerer Saatsubstrate möglich ist. Hierdurch wird eine Kosteneinsparung erzielt.
- Durch die Ausbildung der stofflichen Verbindung ein Halbleitermaterial umfassend kann die gleiche Abscheidetechniken zur Ausbildung der stofflichen Verbindung wie auch zum Erzeugen der Halbleiterschicht auf dem Saatsubstrat verwendet werden. Weiterhin weist Halbleitermaterial als stoffliche Verbindung typischerweise eine hohe Temperaturstabilität auf. Darüber hinaus weist Halbleitermaterial eine gute Haftung an den Saatsubstraten auf.

Die der Erfindung zugrunde liegende Aufgabe ist weiterhin gelöst durch ein Trägerelement gemäß Anspruch 13. Das Trägerelement weist Saatsubstrate zur Beschichtung mit einer Halbleiterschicht auf, wobei die Saatsubstrate an dem Trägerelement angeordnet sind. Wesentlich ist, dass die Saatsubstrate auf das Trägerelement auflegbar und mittels stofflicher Verbindung an dem Trägerelement angeordnet sind, wobei die stoffliche Verbindung zwischen Saatsubstrat und Trägerelement ein Halbleitermaterial umfassend ausgebildet ist, wobei die stoffliche Verbindung das Halbleitermaterial umfassend ausgebildet ist, welches zur Ausbildung der Halbleiterschicht verwendet wird, wobei die Saatsubstrate auf eine Oberfläche des Trägerelements aufgelegt sind und zumindest bereichsweise an seitlichen Stirnseiten der Saatsubstrate eine stoffliche Verbindung mit dem Trägerelement ausgebildet ist, und wobei ein Saatsubstrat mittels stofflicher Verbindung mit dem Trägerelement und mit einem benachbarten Saatsubstrat verbunden ist. Hierdurch ergeben sich die zuvor genannten Vorteile.

Das Aufbringen der Halbleiterschicht erfolgt bevorzugt durch chemische Gasphasenabscheidung (Chemical Vapour Deposition, CVD).

Besonders vorteilhaft ist es, die Halbleiterschicht epitaktisch aufzubringen, insbesondere mittels CVD.

Beim Abscheiden einer Halbleiterschicht, insbesondere einer epitaktischen Abscheidung erwärmt sich das Saatsubstrat typischerweise auf Temperaturen größer 800°C, insbesondere etwa im Bereich 800 °C bis 1400 °C. Die stoffliche Verbindung ist daher vorteilhafterweise derart ausgebildet, dass sie temperaturstabil für Temperaturen bis zu 1000°C, insbesondere bis zu 1200 °C, bevorzugt bis zu 1400 °C ist.

Die stoffliche Verbindung zwischen Saatsubstrat und Trägerelement wird bevorzugt mittels einem oder einer Kombination der Materialien aus der Gruppe Silicium, Germanium, GaAs und andere III-V Halbleiter, Kohlenstoff, Sauerstoff, SiC, II-VI-Halbleiter ausgebildet. Diesen Materialien ist gemein, dass eine temperaturstabile stoffliche Verbindung ausgebildet wird, welche auch im Prozess einer Abscheidung einer Halbleiterschicht, insbesondere einer epitaktischen Abscheidung Bestand hat.

Vorzugsweise wird die stoffliche Verbindung durch chemische Gasphasenabscheidung (Chemical Vapour Deposition, CVD) ausgebildet.

Bevorzugt wird die stoffliche Verbindung mittels epitaktischer Abscheidung ausgebildet.

Hierdurch ergibt sich der Vorteil, dass auf an sich bekannte Verfahren und Vorrichtungen zurückgegriffen werden kann. Insbesondere kann in einer vorteilhaften Ausführungsform das Verfahren und insbesondere vorteilhafterweise auch die Vorrichtung, mit welcher nachfolgend die Halbleiterschicht ausgebildet wird, zunächst, insbesondere in einem vorgelagerten Schritt, zum stofflichen Verbinden zwischen Saatsubstrat und Träger verwendet werden.

Hierzu ist es vorteilhaft, zunächst die Saatsubstrate auf den Träger aufzulegen, insbesondere, ohne dass die Saatsubstrate durch eine Einschub-Fixierung gehalten werden. Anschließend erfolgt die Ausbildung der stofflichen Verbindung bevorzugt durch ein Halbleitermaterial, insbesondere bevorzugt mittels CVD-Abscheidung. Vor einem nachfolgenden Ausbilden der Halbleiterschicht auf dem Saatsubstrat ist es vorteilhaft, zunächst die Oberfläche des Saatsubstrates zu behandeln, insbesondere zu reinigen, bevorzugt durch Ätzschritte und/oder zu porosifizieren, wie weiter unten näher erläutert.

In einer weiteren vorteilhaften Ausführungsform werden zum Fixieren der Saatsubstrate an dem Träger mittels stofflicher Verbindung zunächst die Saatsubstrate mittels einer lösbaren Haltevorrichtung, insbesondere bevorzugt mittels einer lösbaren Klemmvorrichtung an dem Träger fixiert. Solche Vorrichtungen können beispielsweise als lösbare, anschraubbare oder ansteckbare Halter, ansteckbare Federelemente oder anschraubbare Federarme ausgebildet sein. Nach Ausbilden der stofflichen Verbindung werden die lösbaren Fixierelemente entfernt, so dass in einem nachfolgenden Prozessschritt, bei welchem die Halbleiterschicht auf dem Saatsubstrat ausgebildet wird, keine störenden Einflüsse durch die Halteelemente bestehen.

Zur Ausbildung einer qualitativ hochwertigen Halbleiterschicht ist es wesentlich, dass die Halbleiter-Saatsubstrate an der dem Trägerelement abgewandten Seite, auf welcher die Halbleiterschicht erzeugt wird, eine definierte Oberfläche, welche für den Schichterzeugungsprozess optimiert ist, aufweisen. Vorteilhafterweise wird daher vor Ausbilden der stofflichen Verbindung zwischen Saatsubstrat und Trägerelement die dem Trägerelement abgewandte Seite der Saatsubstrate vorbehandelt, insbesondere porosifiziert. Hierdurch wird in einfacher Weise erzielt, dass nach Ausbilden der stofflichen Verbindung eine gegebenenfalls an der dem Trägerelement abgewandten Seite des Saatsubstrates erfolgte Ablagerung des Materials der stofflichen Verbindung entfernt werden kann.

Vorteilhafterweise wird nach Ausbilden der stofflichen Verbindung zwischen Saatsubstrat und Trägerelement und vor Aufbringen der Halbleiterschicht auf das Saatsubstrat die dem Trägerelement abgewandte Seite der Saatsubstrate vorbehandelt, insbesondere mittels Reinigen und/oder Abätzen und/oder Porosifizieren. Alternativ oder zusätzlich ist es vorteilhaft, die dem Trägerelement abgewandte Seite der Saatsubstrate mit einer Deckschicht zu versehen. Eine solche Deckschicht kann als Dielektrikum, beispielsweise einem Oxid oder Nitrid der Halbleiterschicht ausgebildet sein und weist den Vorteil auf, dass eine derartige Schicht nasschemisch entfernt werden kann ohne die stoffliche Verbindung, bestehend aus dem Halbleitermaterial oder einer Komponente davon, zu entfernen. Hierdurch wird die dem Trägerelement abgewandte Seite effektiv geschützt während dem Ausbilden der stofflichen Verbindung, wodurch diese Seite für Folgeprozesse zur Verfügung steht.

Vorteilhafterweise wird auf die an dem Trägerelement angeordneten Saatsubstrate zumindest eine Halbleiterschicht bevorzugt epitaktisch abgeschieden. Hierbei liegt es im Rahmen der Erfindung, dass eine separate Halbleiterschicht jeweils auf ein Saatsubstrat abgeschieden wird. Ebenso liegt es im Rahmen der Erfindung, dass eine Halbleiterschicht, welche mehrere, insbesondere alle Saatsubstrate überdeckt, abgeschieden wird.

Die Halbleiterschicht wird vorteilhafterweise von den Saatsubstraten abgelöst, ohne die stoffliche Verbindung zwischen Saatsubstrat und Trägerelement zu trennen. Hierdurch ergibt sich der Vorteil, dass während des Trennvorgangs das Saatsubstrat zum Erzeugen einer Halbleiterschicht verwendet wird, ohne dass die Notwendigkeit besteht, das Saatsubstrat von dem Träger zu lösen.

Vorzugsweise wird eine Siliziumschicht auf das Saatsubstrat abgeschieden, bevorzugt mit einer Dicke im Bereich 20 µm bis 500 µm, insbesondere im Bereich 30 µm bis 300 µm, insbesondere bevorzugt epitaktisch abgeschieden.

Bevorzugt ist das Saatsubstrat aus dem gleichen Halbleitermaterial ausgebildet, aus dem die Halbleiterschicht erzeugt wird. Besonders vorteilhafterweise wird das erfindungsgemäße Verfahren und das erfindungsgemäße Trägerelement bei der Erzeugung von Silizium-Halbleiterschichten, welche als Siliziumwafer zur Erzeugung von Halbleiterbauelementen, insbesondere photovoltaischen Solarzellen eingesetzt werden, verwendet. Die Saatsubstrate sind daher bevorzugt als Siliziumsubstrate wie beispielsweise Siliziumwafer ausgebildet.

Wie zuvor beschrieben, ist für eine hohe Qualität der Halbleiterschicht eine optimierte Oberfläche des Saatsubstrates vorteilhaft. Es ist bekannt, die dem Trägerelement abgewandte Seite des Saatsubstrates mittels Porosifikation vorzubehandeln, um einerseits eine definierte Oberfläche für das Erzeugen der Halbleiterschicht zu erzielen und andererseits einen definierten Ablösebereich zum Entfernen der erzeugten Halbleiterschicht zu erzeugen, der ein Entfernen mit verringerter Bruchgefahr ermöglicht. Ein solches Verfahren und eine hierfür geeignete Vorrichtung ist aus DE 10 2013 219 886 A1 bekannt. Das Porosifizieren erfolgt, indem ein einseitiger Ätzvorgang an derjenigen Seite des Saatsubstrates erfolgt, an welcher die Halbleiterschicht in einem nachfolgenden Prozessschritt erzeugt werden soll. Hierbei ist es bekannt, lediglich diese Seite mit einem Elektrolyten zu benetzen und mittels einer Konstantstromquelle einen Ätzstrom zwischen dem Elektrolyten und dem Saatsubstrat zu erzeugen, so dass ein einseitiges Ätzen erfolgt. Dies ist ebenfalls in DE 10 2013 219 886 A1 beschrieben.

Vorteilhafterweise erfolgt zunächst eine Anordnung der Saatsubstrate an dem Trägerelement mittels stofflicher Verbindung und anschließend eine einseitige Behandlung der Saatsubstrate an der dem Trägerelement abgewandten Seite durch einen einseitigen Ätzvorgang, insbesondere bevorzugt zur Porosifikation, bevorzugt durch ein Verfahren wie in DE 10 2013 219 886 A1 beschrieben. Hier ergibt sich der Vorteil, dass gleichzeitig eine Mehrzahl von Saatsubstraten, welche an dem Trägerelement angeordnet sind, porosifiziert werden kann und darüber hinaus bei diesem Vorgang eventuelle Rückstände des Materials der stoffschlüssigen Verbindung auf der dem Trägerelement abgewandten Seite der Saatsubstrate entfernt und/oder eingeebnet werden.

Vorteilhafterweise werden dotierte Saatsubstrate mit einer Dotierung des n- oder p-Dotierungstyps verwendet. Diese weisen den Vorteil auf, dass etablierte, elektrochemische Prozesse zur Porosifikation wie z.B. beschrieben in Smith et. al; J. Appl. Phys. 71, R1 (1992); doi: 10.1063/1.350839 angewendet werden können. Hierbei ist es besonders vorteilhaft, die stoffliche Verbindung zwischen Saatsubstrat und Trägerelement ein dotiertes Halbleitermaterial umfassend, insbesondere durch ein n- oder p-dotiertes Halbleitermaterial auszubilden, wobei die stoffliche Verbindung bevorzugt den entgegengesetzten Dotierungstyp zu dem Dotierungstyp der Saatsubstrate aufweist. Hierdurch ergibt sich der Vorteil, dass bei einem Ätzvorgang, bei welchem einseitig die Oberfläche der Saatsubstrate durch ein Elektrolyt benetzt wird und durch Anlegen eines Ätzstromes der Ätzvorgang ausgebildet wird, selektiv durch das Zusammenwirken von Elektrolyt und Dotierungstyp des Saatsubstrates ein Ätzen ausschließlich der Oberfläche der Saatsubstrate, nicht jedoch der stofflichen Verbindung erfolgen kann. Dies wird ermöglicht durch die Sperrwirkung für elektrische Ströme am Übergang zwischen zwei unterschiedlich dotierten Halbleiterbereichen sowie der deutlich unterschiedlichen Ätzprozesse für n- oder p-Typ dotierte Halbleiterschichten.

In einer anderen vorteilhaften Ausbildung wird die stoffliche Verbindung mit identischem Dotiertyp, bevorzugt darüber hinaus mit identischer Konzentration von Dotierstoffen hergestellt um die stoffliche Verbindung ebenfalls oberflächlich zu Porosifizieren. Dies hat den Vorteil, dass beim Wachstum der Halbleiterschicht, insbesondere beim epitaktischen Wachstum die stoffliche Verbindung von Saatsubstrat und Trägerelement zwar verdickt wird, diese Verdickung aber anschließend beim Ablösen der erzeugten Halbleiterschicht ebenfalls entfernt werden kann. Hierdurch kann gewährleitet werden, dass der Verbund aus Saatsubstrat, stofflicher Verbindung und Trägerelement auf der dem Trägerelemente abgewandten Seite eine ebene, stufenfreie Oberfläche ausbildet.

Ein entgegengesetzter Dotierungstyp der stofflichen Verbindung einerseits und der Saatsubstrate andererseits weist darüber hinaus den Vorteil auf, dass auch selektiv ein Ätzvorgang durchgeführt werden kann, welcher ausschließlich an der stofflichen Verbindung angreift, so dass mittels solch eines Ätzvorgangs die stoffliche Verbindung wahlweise gelöst werden kann, insbesondere, um die Saatsubstrate von dem Träger zu lösen und auszutauschen.

Erfindungsgemäß wird ein Saatsubstrat mittels stofflicher Verbindung mit dem Trägerelement und mit einem benachbarten Saatsubstrat verbunden. Bei dieser vorteilhaften Ausführungsform erfolgt die Fixierung der Saatsubstrate somit bevorzugt im Wesentlichen, insbesondere bevorzugt ausschließlich, mittels seitlich an den Saatsubstraten angeordneter stofflicher Verbindungen, welche einerseits an die seitlichen Stirnseiten der Saatsubstrate und andererseits an eine Oberfläche des Trägerelementes anhaften. Es ergibt sich somit eine lateral abwechselnde Abfolge von Saatsubstrat - stofflicher Verbindung, wobei eine stoffliche Verbindung zwischen zwei Saatsubstraten angeordnet ist und an die beiden gegenüberliegenden Stirnseiten der benachbarten Saatsubstrate sowie an eine Oberfläche des Trägerelementes anhaftet.

Hierdurch ist ein prozesstechnisch einfaches Verfahren gegeben, bei welchem die Saatsubstrate auf das Trägerelement aufgelegt werden und anschließend, insbesondere bevorzugt durch einen CVD-Prozess, mittels stofflicher Verbindung mit dem Trägerelement verbunden werden. In einer vorteilhaften Ausgestaltung sind Abstandshalter vorgesehen, um einen definierten lateralen Abstand zwischen den Saatsubstraten zu erzielen und ein Verrutschen während des Ausbildens der stofflichen Verbindung und der vorgelagerten Handhabungsschritte zu vermeiden. Solche Abstandselemente können lösbare Abstandselemente sein, welche nach Ausbilden der stofflichen Verbindung entfernt werden. Ebenso können Mulden in dem Trägerelement zur Aufnahme der Saatsubstrate ausgebildet sein. Ebenso können Abstandselemente an dem Trägerelement ausgebildet sein, welche lediglich an einem oder mehreren Teilbereichen der umlaufenden Stirnseiten der Saatsubstrate anliegen. Bei Abstandselementen, welche zum Ausbilden der Halbleiterschicht nicht entfernt werden, insbesondere bei einstückig mit dem Trägerelement ausgebildeten Abstandselementen ist es vorteilhaft, wenn die Abstandselemente bei an dem Trägerelement angeordneten Saatsubstraten eine geringere Höhe als die Dicke der Saatsubstrate aufweisen. Hierdurch werden die Abstandselemente während des Ausbildens der stofflichen Verbindung bevorzugt durch die stoffliche Verbindung bedeckt, so dass auch bei Ausbilden der Halbleiterschicht die Halbleiterschicht allenfalls auf der stofflichen Verbindung, nicht jedoch unmittelbar an die Abstandselemente angrenzend ausgebildet wird. Hierdurch wird ein unmittelbares Anhaften der Halbleiterschicht an den Abstandselementen, welches beim Ablösen eine Bruchgefahr erhöhen könnte, vermieden.

Wie zuvor beschrieben liegt es im Rahmen der Erfindung, dass auf jedes Saatsubstrat jeweils eine Halbleiterschicht aufgebracht wird. Ebenso liegt es im Rahmen der Erfindung, dass die Halbleiterschichten zweier benachbarter Saatsubstrate miteinander verbunden sind, insbesondere eine gemeinsame Halbleiterschicht ausbilden. Bevorzugt ist es, dass zwischen zwei benachbarten Saatsubstraten die stoffliche Verbindung angeordnet wird und dass an der dem Trägerelement abgewandten Seite die stoffliche Verbindung mit den angrenzenden Saatsubtraten mit einer ebenen Oberfläche, insbesondere einer gemeinsamen ebenen Oberfläche ausgebildet wird. Dies kann bevorzugt dadurch erzielt werden, dass zunächst das Ausbilden der stofflichen Verbindung erfolgt und anschließend die ebene Oberfläche in einem Oberflächenbehandlungsschritt ausgebildet wird, beispielsweise durch mechanische Oberflächenbehandlung und/oder Ätzen.

Vorzugsweise wird auf die an dem Trägerelement mittels stofflicher Verbindung angeordneten Saatsubstrate zumindest eine Halbleiterschicht aufgebracht und vor Ablösen der Halbleiterschicht erfolgt ein Trennschnitt im Bereich zwischen zwei benachbarten Saatsubstraten. Dieser Trennschnitt kann durch Materialabtrag, insbesondere durch mechanischen Materialabtrag, durch Ablation, insbesondere Laserablation oder chemisch, insbesondere durch einen Ätzvorgang erfolgen. Bevorzugt durchdringt der Trennschnitt zumindest die aufgebrachte Halbleiterschicht. Hierdurch wird somit sichergestellt, dass vor Ablösen der Halbleiterschichten eine Vereinzelung vorliegt, so dass jedem Saatsubstrat jeweils eine erzeugte Halbleiterschicht zugeordnet ist und bei Ablösen einer Halbleiterschicht keine Bruchgefahr durch eine etwaige Verbindung dieser Halbleiterschicht mit einer benachbarten Halbleiterschicht besteht.

Es liegt im Rahmen der Erfindung, die Halbleiterschicht zunächst vollständig abzulösen. Hierdurch können besonders großflächige Halbleiterschichten erzeugt werden. Ebenso kann die Halbleiterschicht nach Ablösen vereinzelt werden, beispielsweise durch Trennschnitte insbesondere mittels Sägen oder mittels eines Lasers.

Sofern zwischen den Halbleitersubstraten eine stoffliche Verbindung ausgebildet ist, erfolgt bevorzugt der Trennschnitt nicht oder nur geringfügig bis in den Bereich der stofflichen Verbindung, um ein Lösen oder ein Schwächen der stofflichen Verbindung durch den Trennschnitt zu vermeiden.

Vorzugsweise werden die Saatsubstrate zumindest an der dem Trägerelement zugewandten Seite mittels stofflicher Verbindung mit dem Trägerelement verbunden. In dieser vorteilhaften Ausführungsform kann eine besonders stabile, insbesondere eine großflächige stoffliche Verbindung zwischen Trägerelement und Saatsubstrat erzielt werden. Hierbei ist es vorteilhaft, dass das Trägerelement eine Öffnung aufweist, so dass die Saatsubstrate an dem Trägerelement angeordnet werden und mittels einer, bevorzugt mittels mehrerer Öffnungen im Trägerelement Material zur stofflichen Verbindung zwischen Saatsubstrat und Trägerelement eingebracht wird. Hier ist es vorteilhaft, die stoffliche Verbindung mittels chemischer Gasphasenabscheidung (Chemical Vapour Deposition, CVD), insbesondere mittels epitaktischer Abscheidung, insbesondere bei Atmosphärendruck oder bei Prozessdrücken kleiner Atmossphärendruck, insbesondere mittels LPCVD (low pressure CVD), auszubilden. Hierdurch wird eine Infiltration der Prozessgase in das Trägerelement und an die Öffnungen zur Erzeugung der stofflichen Verbindung vereinfacht.

In einer weiteren vorteilhaften Ausgestaltung wird die stoffliche Verbindung zwischen Trägerelement und Saatsubstrat mittels Plasmaspritzen oder Flammspritzen ausgebildet. Hierdurch werden schnelle und kostengünstige Verfahren ermöglicht.

In einer weiteren vorteilhaften Ausführungsform werden an zwei gegenüberliegenden Seiten des Trägerelementes jeweils Saatsubstrate mittels stofflicher Verbindung angeordnet. Hierdurch ergibt sich der Vorteil, dass besonders raumsparend der Prozessraum beim Aufbringen der Halbleiterschicht ausgenutzt werden kann, da beidseitig des Trägerelements Halbleiterschichten abgeschieden werden können.

Hier zeigt sich ein besonderer Vorteil des erfindungsgemäßen Verfahrens und des erfindungsgemäßen Trägerelementes: Durch die stoffliche Verbindung ist ein besonders stabiles Anhaften der Saatsubstrate an dem Trägerelement gegeben, so dass bei den einzelnen Bearbeitungsschritten, insbesondere bei der Oberflächenbehandlung beispielsweise mittels Porosifizieren vor Aufbringen der Halbleiterschicht oder beim Ablösen der Halbleiterschicht auch ein sequentielles Bearbeiten der Seiten des Trägers möglich ist, insbesondere eine waagerechte Anordnung des Trägers mit untenliegenden, stofflich verbundenen Saatsubstraten. Denn die stoffliche Verbindung zwischen Saatsubstrat und Träger verhindert ein Abfallen oder Herausrutschen der Saatsubstrate, so dass ein einfaches Handling auch bei beidseitiger Verwendung des Trägers möglich ist.

Eine vorteilhaft stabile und dennoch wahlweise einfach lösbare stoffliche Verbindung ergibt sich, indem das Saatsubstrat zumindest teilweise stirnseitig und in einem Teilbereich an der dem Trägerelement zugewandten Seite stofflich mit dem Trägerelement verbunden wird. Hierdurch ist eine erhöhte Stabilität der stofflichen Verbindung gegeben.

Dennoch kann beispielsweise durch einen Ätzvorgang in einfacher Weise die seitliche stoffliche Verbindung sowie die nur in Teilbereichen an der dem Trägerelement zugewandten Seite bestehende stoffliche Verbindung gelöst werden. Hierbei ist es insbesondere vorteilhaft, wenn die an der dem Trägerelement zugewandten Seite ausgebildete stoffliche Verbindung an einem oder mehreren Randbereichen des Saatsubstrates ausgebildet wird, da hier in einfacher Weise mechanisch oder mittels eines Ätzvorgangs ein Lösen solch einer Verbindung möglich ist. Dies ermöglicht insbesondere ein einfacheres Ablösen eines Saatsubstrates von dem Trägerelement verglichen mit einer großflächigen, insbesondere ganzflächigen stofflichen Verbindung zwischen Saatsubstrat und Trägerelement an der dem Trägerelement zugewandten Seite des Saatsubstrates.

Wie zuvor beschrieben, ermöglicht das erfindungsgemäße Verfahren eine mehrfache Verwendung der Saatsubstrate. Es ist daher vorteilhaft, dass die Saatsubstrate mittels stofflicher Verbindung an dem Trägerelement angeordnet werden und ohne die stoffliche Verbindung zwischen Saatsubstrat und Trägerelement zu trennen mehrfach die Prozessabfolge
- Vorbehandeln der dem Trägerelement abgewandten Seite der Saatsubstrate,
- Aufbringen zumindest einer Halbleiterschicht auf die Saatsubstrate,
- Ablösen der Halbleiterschicht von den Saatsubstraten
mit oder ohne Zwischenschaltung von weiteren Zwischenschritten durchgeführt wird, insbesondere zumindest 20 Mal, bevorzugt zumindest 50 Mal durchgeführt wird. Hierdurch wird ein kosteneffizientes Herstellungsverfahren erzielt.

Vorzugsweise weist das Trägerelement zumindest eine Auflage für jedes Saatsubstrat auf, an welcher eine dem Trägerelement zugewandte Rückseite des Saatsubstrates unmittelbar an dem Trägerelement anliegt. Weiterhin weist das Trägerelement im Randbereich jedes Saatsubstrates zumindest eine Vertiefung, bevorzugt eine um den Rand des Saatsubstrates umlaufende Vertiefung auf, an welcher die Rückseite des Saatsubstrates stoffflüssig mit dem Träger verbunden ist. Hierdurch werden die zuvor genannten Vorteile erzielt. Insbesondere untergreift vorteilhafterweise die Ausnehmung zumindest bereichsweise, bevorzugt umlaufend den Randbereich der dem Trägerelement zugewandten Rückseite des Saatsubstrates.

Die Saatsubstrate weisen bevorzugt Kantenlängen im Bereich 10 cm bis 50 cm auf und sind bevorzugt rechteckig, insbesondere bevorzugt quadratisch ausgebildet. Das Trägerelement ist bevorzugt zur Aufnahme von zumindest 9, bevorzugt zumindest 12, weiter bevorzugt zumindest 16, weiter bevorzugt zumindest 20 Saatsubstraten ausgebildet.

Die Halbleiterschicht ist vorteilhafterweise aus Silizium ausgebildet. Die Halbleiterschicht wird bevorzugt mittels eines an sich bekannten Verfahrens, insbesondere wie in Habuka et al. "Model on transport phenomena and epitaxial growth of silicon thin film in SiHCl3-H2 system under atmospheric pressure", Journal of Crystal Growth 169 (1996) 61-72 oder Narusawa, "Si Deposition from Chlorosilanes", J. Electrochem. Soc., Vol. 141, No. 8, August 1994 beschrieben. Das Trägerelement ist bevorzugt aus einem oder mehreren der Materialien Graphit, Silicium, Quarz, Siliciumcarbid oder Siliciumnitrid oder Kompositen und Verbünden aus diesen Materialien ausgebildet. Das Trägerelement weist bevorzugt eine Dicke im Bereich 0,1 cm bis 15 cm, insbesondere bevorzugt 0,3 cm bis 8 cm auf. Vorzugsweise weist das Trägerelement einen thermischen Ausdehnungskoeffizienten auf, welcher an die Ausdehnung der Halbleiterschicht angepasst ist.

Die Halbleiter-Saatsubstrate werden bevorzugt ersetzt, wenn sie "verbraucht" sind. Dies kann sich durch Unterschreiten einer vorgegebenen Mindestdicke, nach Durchlaufen einer vorgegebenen Anzahl von Prozesszyklen oder durch individuelle Kontrolle, insbesondere auf Brüche oder stark inhomogene Abnutzungen zeigen. Hierzu kann beispielsweise mittels Ätzen die stoffliche Verbindung vollständig entfernt werden, so dass die Saatsubstrate von dem Trägerelement entfernt werden können. Anschließend wird das Trägerelement wiederverwendet, indem neue Saatsubstrate mittels stofflicher Verbindung an dem Trägerelement angeordnet werden.

In einer bevorzugten Ausführungsform wird die Dicke der Saatsubstrate erhöht, um einer zu starken Abnutzung entgegenzuwirken. Hierzu wird somit Material der Saatsubstrate auf der dem Trägerelement abgewandten Seite der Saatsubstrate aufgebracht, bevorzugt epitaktisch aufgebracht. In diesem Fall wird somit keine Zwischenschicht und insbesondere keine Porosifizierung der Oberfläche der Saatsubstrate vorgenommen, da die neu aufgebrachte Schicht dauerhaft auf der Oberfläche der Saatsubstrate verbleiben soll.

In diesem Ausführungsbeispiel wird die Dicke der Saatsubstrate somit mittels Epitaxie wieder erhöht, so dass eine weitere Verwendung im vorbeschriebenen Prozesskreislauf möglich ist. Die Erhöhung der Dicke der Saatsubstrate erfolgt bevorzugt bei Unterschreiten einer vorgegebenen Mindestdicke, nach Durchlaufen einer vorgegebenen Anzahl von Prozesszyklen oder durch individuelle Kontrolle, insbesondere optische Kontrolle.

Weitere bevorzugte Merkmale und Ausführungsformen werden im Folgenden anhand der Figuren und von Ausführungsbeispielen erläutert. Dabei zeigt:
- Figur 1: eine Teilschnittdarstellung eines Ausführungsbeispiels eines erfindungsgemäßen Trägerelementes mit stofflich verbundenen Saatsubstraten;
- Figur 2: eine perspektivische Teilansicht des Trägerelementes gemäß Figur 1;
- Figur 3: einen Zwischenschritt eines Ausführungsbeispiels des erfindungsgemäßen Verfahrens mit aufgebrachtem Verbindungsmaterial;
- Figur 4: einen weiteren Zwischenschritt des Ausführungsbeispiels des erfindungsgemäßen Verfahrens nach Durchführen eines Trennschnitts;
- Figur 5: ein weiteres Ausführungsbeispiel eines erfindungsgemäßen Trägerelementes mit Abstandhaltern;
- Figur 6: ein weiteres Ausführungsbeispiel eines erfindungsgemäßen Trägerelementes mit lösbar anbringbaren Halteelementen;
- Figur 7: ein weiteres Ausführungsbeispiel eines erfindungsgemäßen Trägerelementes mit beidseitig angeordneten Saatsubstraten;
- Figur 8: ein weiteres Ausführungsbeispiel eines erfindungsgemäßen Trägerelementes mit lösbar anbringbaren Halteelementen und großflächig stofflicher Verbindung zwischen Saatsubstrat und Trägerelement und
- Figur 9: ein weiteres Ausführungsbeispiel eines erfindungsgemäßen Trägerelements mit stofflich verbundenen Saatsubstraten, wobei die stoffliche Verbindung an den Stirnseiten des Saatsubstrates sowie umlaufend begrenzt an der dem Trägerelement zugewandten Seite des Saatsubstrates erfolgt.

Sämtliche Figuren zeigen schematische, nicht maßstabsgetreue Darstellungen. Gleiche Bezugszeichen bezeichnen gleiche oder gleichwirkende Elemente.

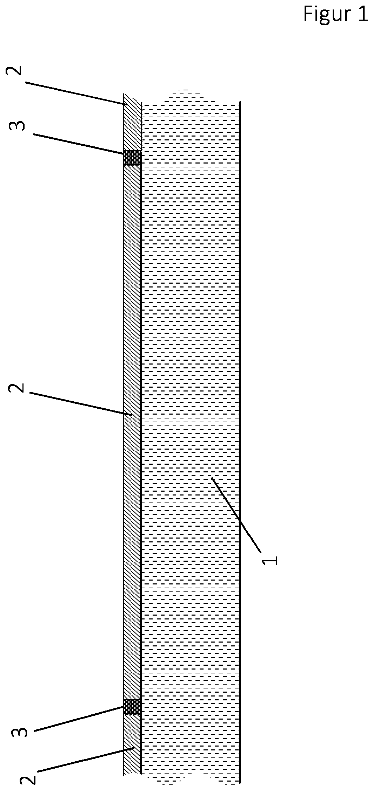

Figur 1 zeigt ein Ausführungsbeispiel eines erfindungsgemäßen Trägerelementes 1, an welchem an einer Oberseite mehrere Saatsubstrate 2 angeordnet sind.

Das Trägerelement ist ausgebildet als Graphitplatte und zur Anordnung von 3x3 Saatsubstraten 2 ausgebildet. Das Trägerelement weist eine Dicke von 10 mm auf. Die Saatsubstrate sind als Siliziumwafer mit einer quadratischen Grundform ausgebildet, wobei die Kantenlänge vorliegend 157 mm beträgt. Die Saatsubstrate weisen eine p-Dotierung mittels Bor als Dotierstoff, im Bereich 1x10¹⁸ At./cm³ bis 1x10¹⁹ At./cm³, vorliegend etwa 5x10¹⁸ At./cm³ auf.

An den seitlichen Stirnseiten der Saatsubstrate 2 ist jeweils zwischen den Saatsubstraten eine stoffliche Verbindung 3 angeordnet. Die stoffliche Verbindung ist aus n-dotiertem Silizium mit Phosphor als Dotierstoff ausgebildet, mit einer Dotierkonzentration im Bereich 5x10¹⁴ At./cm³ bis 3x10¹⁵ At./cm³, vorliegend 9x10¹⁴ At./cm³ cm⁻³.

Die stoffliche Verbindung 3 haftet einerseits an den seitlichen Stirnseiten der Saatsubstrate 2 an und andererseits an der in Figur 1 oben liegend gezeichneten Oberfläche des Trägerelementes 1. Die Saatsubstrate 2 sind somit mittels der stofflichen Verbindung 3 an dem Trägerelement 1 fixiert. Die stoffliche Verbindung 3 bedeckt dabei mindestens 2 Stirnseiten des Saatsubstrats 2, vorteilhafterweise alle 4 Stirnseiten des Saatsubstrates 2.

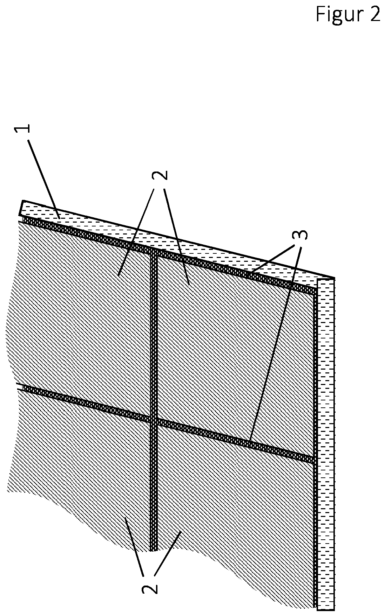

Figur 2 zeigt eine perspektivische Teildarstellung des Trägerelementes 1. Gezeigt ist die rechte untere Ecke, wobei vier Saatsubstrate ersichtlich sind. Lateral zwischen den seitlichen Stirnseiten der Saatsubstrate 2 ist jeweils eine stoffliche Verbindung 3 angeordnet. Die stoffliche Verbindung ist an allen 4 Stirnseiten der Saatsubstrate ausgebildet.

Die Figuren 1 und 2 zeigen somit ebenfalls das Ergebnis eines Ausführungsbeispiels eines erfindungsgemäßen Verfahrens zum Anordnen mehrerer Saatsubstrate 2 an einem Trägerelement 1, wobei die Saatsubstrate 2 mittels stofflicher Verbindung 3 an dem Trägerelement angeordnet werden.

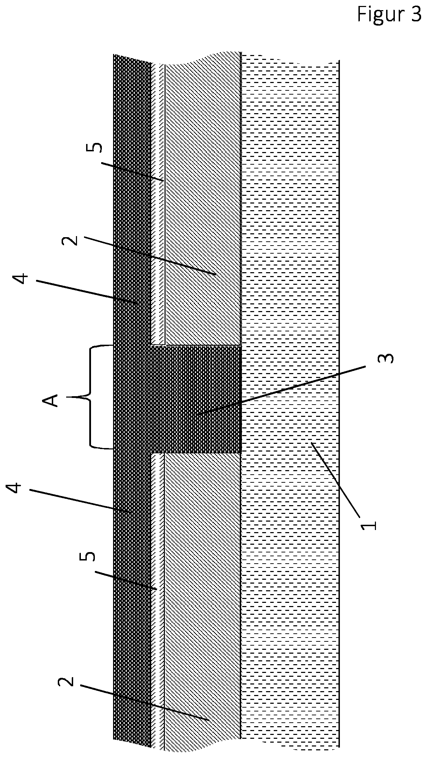

Figur 3 zeigt einen Teilschritt dieses ersten Ausführungsbeispiels: Zunächst wurden die Saatsubstrate 2 einzeln an einer Oberfläche porosifiziert, um eine Trennschicht 5 zu erzeugen. Dies wurde mittels des an sich bekannten einseitigen Ätzvorgangs durchgeführt, wie zuvor beschrieben. Anschließend wurden die Saatsubstrate 2 auf dem Trägerelement 1 angeordnet, mit einem lateralen Abstand A im Bereich 0,1 mm bis 10 mm, vorliegend 2 mm, wobei die an der Oberfläche der Saatsubstrate 2 mittels Porosifikation ausgebildete Trennschicht 5 an der dem Trägerelement 1 abgewandten Seite angeordnet wurde.

Anschließend wurde das Trägerelement in einer Anlage zur CVD-Abscheidung geführt und mittels chemischer Gasphasenabscheidung Silizium abgeschieden. Das Ergebnis ist in Figur 3 dargestellt:
Die Abscheidung führte zur Ausbildung der stofflichen Verbindung 3, welche die seitlichen Stirnseiten der Saatsubstrate 2 mit dem Trägerelement 1 verbindet.

Darüber hinaus erfolgte jedoch auch eine Abscheidung einer parasitären stofflichen Verbindung 4 auf den Saatsubstraten 2. Da an den Oberflächen der Saatsubstrate 2 jedoch eine Trennschicht 5 ausgebildet wurde, kann in einem nachfolgenden Schritt in einfacher Weise ein Abtrennen der parasitären stofflichen Verbindung 4 erfolgen, so dass nur die stoffliche Verbindung 3 verbleibt.

Im Bereich zwischen parasitärer stofflicher Verbindung 4 und stofflicher Verbindung 3 bricht die stoffliche Verbindung durch. Hier wird in einer bevorzugten Ausführungsform anschließend mechanisch oder mittels Ätzen die stoffliche Verbindung 3 eingeebnet, so dass die dem Trägerelement 1 abgewandte Seite der stofflichen Verbindung 3 eine ebene Fläche mit der dem Trägerelement 1 abgewandten Seite der Saatsubstrate 2 bildet.

Alternativ kann die parasitäre stoffliche Verbindung 4 mechanisch entfernt werden, insbesondere abgeschliffen werden. Hierzu ist das Ausbilden einer Trennschicht 5 nicht zwingend notwendig. Weiterhin kann alternativ die parasitäre stoffliche Verbindung 4 mittels Ätzen entfernt werden. Hier ist ebenfalls eine Trennschicht 5 nicht zwingend notwendig. In dieser vorteilhaften Ausgestaltung ist es insbesondere vorteilhaft, dass die Saatsubstrate 2 eine entgegengesetzte Dotierung zu der stofflichen Verbindung 3 aufweisen. In diesem Fall kann ein Ätzvorgang mittels eines Elektrolyten und Einprägen eines Ätzstroms durchgeführt werden, welcher selektiv lediglich die stoffliche Verbindung 3 ätzt und somit an der Oberfläche der Saatsubstrate 2 stoppt.

In einer weiteren vorteilhaften Abwandlung wird vor Entfernen der parasitären stofflichen Verbindung 4 ein Trennschnitt im Bereich A durchgeführt, insbesondere mittels Laserablation, welcher in etwa die Tiefe der Dicke der parasitären stofflichen Verbindung 4 aufweist. Auf diese Weise wird besonders effizient vermieden, dass bei Entfernen der parasitären stofflichen Verbindung 4 eine Beschädigung oder Verringerung der Haftkraft der stofflichen Verbindung 3 auftritt.

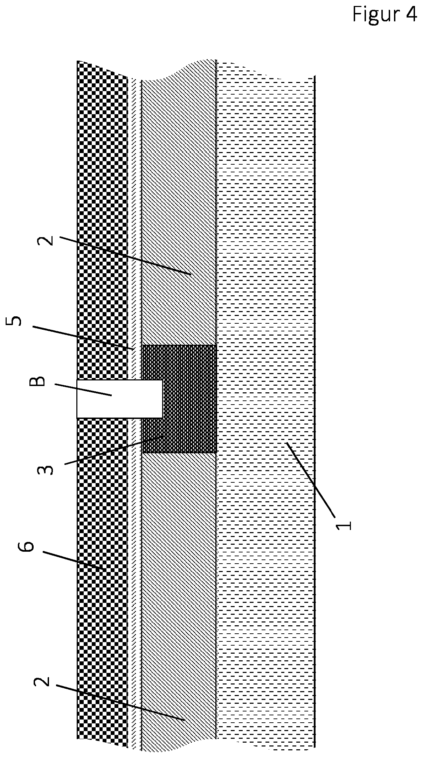

Figur 4 zeigt einen weiteren Teilschritt des ersten Ausführungsbeispiels: Nach Anordnen der Saatsubstrate 2 mittels stofflicher Verbindung 3 und Entfernen der parasitären stofflichen Verbindung 4 wurde die Oberfläche der Saatsubstrate 2 vorbehandelt: Mittels einseitiger Benetzung mit einem Elektrolyten und Aufprägen eines Ätzstroms wurde wie zuvor beschrieben eine Trennschicht 5 auf den Oberflächen der Saatsubstrate 2 mittels Porosifikation erzeugt. Hier zeigt sich ein Vorteil der vorliegenden Erfindung: Das Ausbilden der Trennschicht an der Oberfläche der Saatsubstrate 2 kann erfolgen, ohne die Saatsubstrate von dem Trägerelement 1 zu lösen, so dass in effizienter Weise sämtliche an dem Trägerelement 1 angeordnete Saatsubstrate 2 an der Oberfläche in einem Verfahrensschritt behandelt werden können.

Nach Ausbilden der Trennschicht 5 wurde das Trägerelement 1 mit den Saatsubstraten 2, welche mittels stofflicher Verbindung 3 an dem Trägerelement 1 fixiert sind, in eine CVD-Anlage geführt, um in an sich bekannter Weise eine Halbleiterschicht 6 abzuscheiden. In diesem Ausführungsbeispiel erstreckt sich die Halbleiterschicht 6 über sämtliche Saatsubstrate 2 und die dazwischenliegende stoffliche Verbindung 3, wie in Figur 4 dargestellt.

Zum Ablösen der Halbleiterschicht 6 erfolgt zunächst eine Vereinzelung mittels Trennschnitten B. Diese Trennschnitte werden ebenfalls mittels Laserablation durchgeführt und trennen die Halbleiterschicht 6 entlang der stofflichen Verbindung 3, d. h. entlang der Zwischenräume zwischen den Saatsubstraten 2, so dass im Ergebnis jedem Saatsubstrat 2 eine Halbleiterschicht 6 zugeordnet ist, welche jeweils ein Teil der zuvor überdeckenden Halbleiterschicht 6 darstellt.

Der Trennschnitt B ist derart gewählt, dass er zumindest die Dicke der Halbleiterschicht 6 vollständig durchtrennt und vorsorglich geringfügig (vorliegend etwa 0,05 mm) in die stoffliche Verbindung 3 eingreift, um eine vollständige Durchtrennung der Halbleiterschicht 6 sicherzustellen. Der Trennschnitt B durchgreift die stoffliche Verbindung 3 jedoch nur geringfügig und keineswegs vollständig, so dass die Haftwirkung der stofflichen Verbindung 3 nicht beeinträchtigt ist.

Anschließend erfolgt ein mechanisches Ablösen der einzelnen Halbleiterschichten 6 von den Saatsubstraten 2.

Aufgrund der vorliegend entgegengesetzten Dotierung zwischen Saatsubstraten 2 einerseits und stofflicher Verbindung 3 andererseits kann sich die Trennschicht 5 im Bereich der stofflichen Verbindung 3 auch dünner oder gar nicht ausbilden. In diesem Fall bildet sich bei Abscheiden der Halbleiterschicht 5 eine stabilere Verbindung zwischen Halbleiterschicht 6 und stofflicher Verbindung 3 aus. Durch den Trennschnitt B kann jedoch auch in diesem Fall ein bruchunanfälliges Ablösen der vereinzelten Halbleiterschichten erfolgen. Bevorzugt weist in diesen Fällen der Trennschnitt B eine Breite auf, welche zumindest 90% des Abstandes zwischen den Saatsubstraten entspricht, insbesondere bevorzugt 90% bis 99%. Ebenso kann der Trennschritt die volle Breite des Abstands zwischen den Saatsubstraten oder eine größere Breite als der Abstand zwischen den Saatsubstraten aufweisen, um eine Verbindung der Halbleiterschicht mit dem Bereich zwischen den Saatsubstraten sicher zu vermeiden.

In einem alternativen Ausführungsbeispiel weist die stoffliche Verbindung 3 den gleichen Dotierungstyp wie die Saatsubstrate 2, bevorzugt auch den gleichen Dotierstoff und insbesondere bevorzugt auch die gleiche Dotierkonzentration auf. Hierdurch wird gewährleistet, dass sich die Trennschicht 5 zwischen den Halbleitersubstraten 2 auch über die stoffliche Verbindung 3 erstreckt.

Wie in Figur 4 ersichtlich, ergibt sich hierdurch der Vorteil, dass die Halbleiterschichten 6 geringfügig größer sind, als die Saatsubstrate 2, aufgrund der Überlappung der stofflichen Verbindung 3. In einer weiteren Nachbehandlung kann somit eine Kantendefinition der Halbleiterschicht 6 erfolgen, in dem zum Beispiel mittels Laserschneiden umlaufend der Randbereich der Halbleiterschicht 6 abgeschnitten wird, um die Größe des Saatsubstrates 2 zu erzielen. Hierdurch ist zum einen eine exakte Kantendefinition und eine exakte Form gegeben, darüber hinaus sind Randbereiche, in denen auf Kristallebene oder bei Abscheiden einer dotierten Halbleiterschicht auf Dotierebene Unregelmäßigkeiten vorliegen können entfernt, so dass eine qualitativ hochwertige Halbleiterschicht 6 erzielt wird.

Anschließend erfolgt erneut eine Oberflächendefinition der Saatsubstrate 2, in dem die an dem Trägerelement 1 mittels der stofflichen Verbindung 3 fixierten Saatsubstrate 2 erneut wie zuvor beschrieben mit einer Trennschicht 5 versehen werden. Anschließend erfolgt erneut das Abscheiden einer Halbleiterschicht 6. Hier ist anzumerken, dass ein gegebenenfalls in dem zuvor erfolgten Trennschnitt B erfolgte teilweise Entfernung der stofflichen Verbindung 3 bei dem nun erneuten Abscheiden einer Halbleiterschicht 6 durch Halbleitermaterial wieder aufgefüllt wird. Anschließend erfolgen wiederum ein Trennschnitt und ein Ablösen der nun erneut erzeugten Halbleiterschichten 6.

Dieser Zyklus wird mehrere Male wiederholt, wobei sich bei jedem Durchgang die Dicke der Saatsubstrate aufgrund des Erzeugens der Trennschicht geringfügig verringert. Die Dicke der Saatsubstrate von 100 µm bis 2 mm, vorliegend 0,5 mm, erlaubt jedoch eine Durchführung des Verfahrens mit 100 Zyklen.

Hier zeigt sich somit ein besonderer Vorteil der vorliegenden Erfindung: Die Verfahrensschritte zum Anordnen der Saatsubstrate an dem Trägerelement mittels der stofflichen Verbindung 3 müssen lediglich einmalig durchgeführt werden und anschließend kann eine Vielzahl von Prozessdurchläufen zum Herstellen von Halbleiterschichten 6 vorgenommen werden.

Hier ist auch relevant, dass in jedem Verfahrensschritt, insbesondere auch bei Ablösen der Halbleiterschichten 6 die Saatsubstrate 2 das Bruchrisiko der Saatsubstrate 2 deutlich verringert ist.

Haben die Saatsubstrate 2 eine Mindestdicke unterschritten, so kann beispielsweise mittels Ätzen die stoffliche Verbindung 3 vollständig entfernt werden, so dass die Saatsubstrate von dem Trägerelement 1 entfernt werden können. Anschließend wird das Trägerelement wiederverwendet, indem neue Saatsubstrate 2 mittels stofflicher Verbindung wie zuvor beschrieben an dem Trägerelement 1 angeordnet werden.

In einem alternativen Ausführungsbeispiel wird die Dicke der Saatsubstrate 2 mittels Epitaxie wieder erhöht, so dass eine weitere Verwendung im vorbeschriebenen Prozesskreislauf möglich ist.

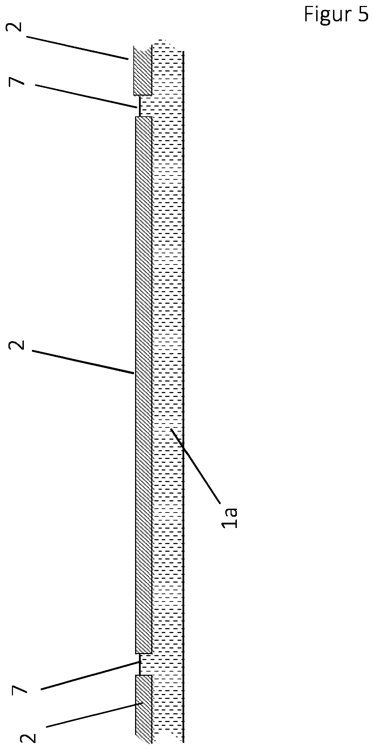

Figur 5 zeigt ein zweites Ausführungsbeispiel eines erfindungsgemäßen Trägerelementes. Dieses Ausführungsbeispiel weist Abstandselemente 7 auf, welche einstückig mit dem Trägerelement 1a ausgebildet sind. Hierbei sind an jeder Seite der Saatsubstrate 3 Abstandselemente 7 etwa gleich verteilt angeordnet, so dass ein zwischen die Abstandselemente 7 eingelegtes Saatsubstrat 2 lateral in beide Raumrichtungen fixiert ist. Die Abstandselemente 7 weisen jedoch eine geringere Höhe als die Saatsubstrate 2 auf. Durch die Abstandselemente 7 wird vermieden, dass bei dem nachfolgenden Erzeugen der stofflichen Verbindung 3 aufgrund äußerer Einflüsse wie Vibrationen oder Stöße ein Verrutschen der Saatsubstrate 2 erfolgt. In den Bereichen, in welchen die Abstandselemente 7 angeordnet sind, wird die stoffliche Verbindung 3 auf den Abstandselementen 7 angeordnet. Zwischen den Abstandselementen 7 ergibt sich hingegen ein Querschnitt wie beispielsweise in Figur 1 dargestellt.

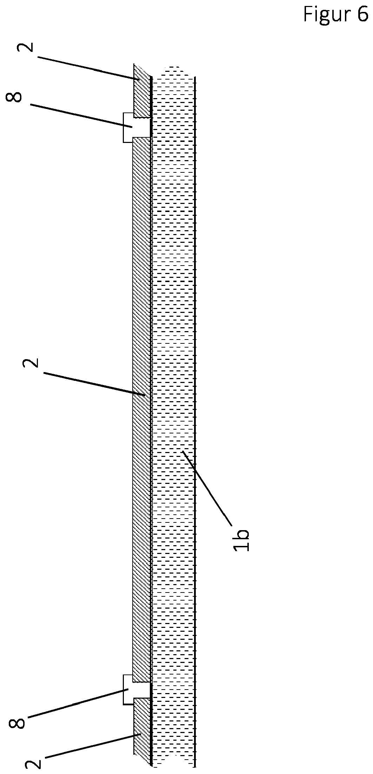

Figur 6 zeigt ein weiteres Ausführungsbeispiel eines Trägerelementes: Das Trägerelement 1b weist Bohrungen auf, in welche mit einem Gewinde versehene Halteelemente 8 eingeschraubt werden können. Mittels dieses Trägerelementes 1b werden somit zunächst die Saatsubstrate 2 aufgelegt und anschließend durch Einschrauben der Halteelemente 8 fixiert, so dass die Saatsubstrate 2 in allen drei Raumrichtungen fixiert sind, da die Halteelemente 8 mit einem Pilzkopf ausgebildet sind.

Anschließend erfolgt das Erzeugen einer stofflichen Verbindung 3. Diese fixiert somit die Saatsubstrate 2 an dem Trägerelement 1b in den Bereichen, in denen sich kein Halteelement 8 befindet. Anschließend können die Halteelemente 8 in einfacher Weise durch Herausschrauben gelöst werden. Bei einem nachfolgenden Verfahrensschritt, in welchem die Halbleiterschicht abgeschieden wird, werden die Gewinde und die zuvor durch die Halteelemente 8 ausgeführten Zwischenbereiche zwischen den Saatsubstraten 2 ebenfalls durch das Material der Halbleiterschicht gefüllt.

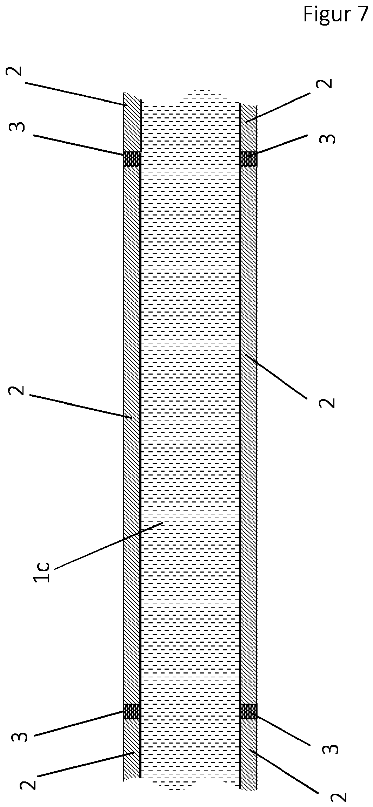

In Figur 7 ist ein weiteres Ausführungsbeispiel eines erfindungsgemäßen Verfahrens dargestellt. Dieses Verfahren entspricht grundsätzlich dem ersten Ausführungsbeispiel. Zusätzlich wurde jedoch nach Fixieren der Saatsubstrate 2 an einer ersten Seite des Trägerelementes 1c mittels der stofflichen Verbindung 3 durch Umdrehen des Trägerelementes 1c der Vorgang wiederholt, indem nochmals auf die nun nicht belegte, oben liegende Seite des Trägerelementes 1c Saatsubstrate 2 angeordnet und mittels stofflicher Verbindung 3 fixiert werden.

Hierdurch ergibt sich eine beidseitige Belegung mit Saatsubstraten, wie in Figur 7 dargestellt. Dies erlaubt eine besonders effiziente Ausnutzung einer Abscheideanlage für die Halbleiterschicht 6.

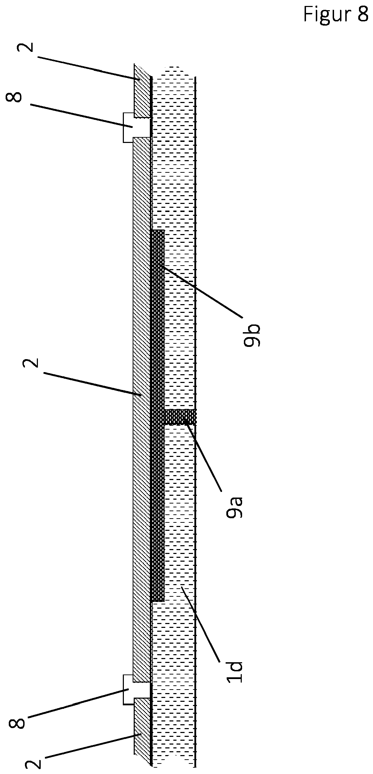

In einem weiteren Ausführungsbeispiel eines erfindungsgemäßen Trägerelementes 1d erfolgt eine besonders stabile, flächige Fixierung der Saatsubstrate 2 an dem Trägerelement 1d. Wie in Figur 8 ersichtlich, weist das Trägerelement 1d eine durchgehende Füllöffnung 9a und eine Verbindungswanne 9b auf. Hierbei werden nach Auflegen der Saatsubstrate 2 auf das Trägerelement 1d die Saatsubstrate 2 zunächst mittels Einschrauben von Halteelementen 8 analog zu dem Vorgehen gemäß Figur 6 fixiert. Anschließend erfolgt ein Zuführen von Material zum Ausbilden der stofflichen Verbindung 3 durch die Füllöffnung 9a in die Verbindungswanne 9b. Hierbei verhindern die Halteelemente 8 ein Abheben der Saatsubstrate 2 nach oben. Durch die Verbindungswanne 9b wird eine großflächige stoffliche Verbindung zwischen Saatsubstrat 2 und Trägerelement 1d erzielt.

Anschließend erfolgt ein Lösen der Halteelemente 8 und das Vorbehandeln der Saatsubstrate 2 und Abscheiden einer Halbleiterschicht 6 wie zuvor beschrieben.

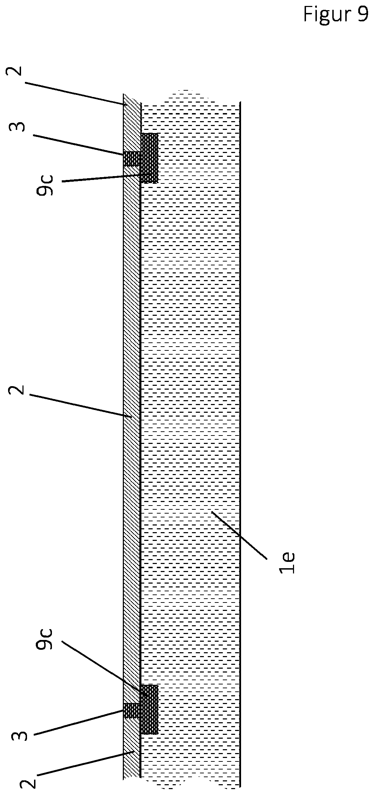

In Figur 9 ist ein weiteres Ausführungsbeispiel eines Trägerelementes 1e dargestellt. Dieses Trägerelement 1e weist ebenfalls Verbindungswannen 9c auf, die jedoch die Zwischenräume zwischen den Saatsubstraten 2 an der den Saatsubstraten 2 zugewandten Seite des Trägerelementes 1e überdecken. In diesem Ausführungsbeispiel ist somit keine Füllöffnung notwendig: Nach Auflegen der Saatsubstrate 2 auf das Trägerelement 1e erfolgt bei Ausbilden der stofflichen Verbindung 3 auch ein Füllen der Verbindungswannen 9c mit stofflicher Verbindung 3. Die Verbindungswannen 9c untergreifen in einem Randbereich der dem Trägerelement 1e zugewandten Rückseite der Saatsubstrate 2 die Saatsubstrate, so dass eine stoffliche Verbindung zwischen Trägerelement 1e nicht nur an den seitlichen Stirnseiten der Saatsubstrate 2, sondern auch in Randbereichen der Rückseite der Saatsubstrate 2 erfolgt. Hierdurch ist ebenfalls eine besonders stabile Fixierung gewährleistet.

## Patentansprüche

1. Verfahren zum Anordnen mehrerer Halbleiter-Saatsubstrate (2) an einem Trägerelement (1, 1a, 1b, 1c, 1d, 1e), zum Aufbringen einer Halbleiterschicht (6) auf die Saatsubstrate (2),
wobei die Saatsubstrate (2) auf das Trägerelement (1, 1a, 1b, 1c, 1d, 1e) aufgelegt und mittels stofflicher Verbindung (3) an dem Trägerelement (1, 1a, 1b, 1c, 1d, 1e) angeordnet werden, wobei die stoffliche Verbindung (3) zwischen Saatsubstrat (2) und Trägerelement (1, 1a, 1b, 1c, 1d, 1e) ein Halbleitermaterial umfassend ausgebildet wird, welches zur Ausbildung der Halbleiterschicht (6) verwendet wird, wobei die Saatsubstrate (2) auf eine Oberfläche des Trägerelements (1, 1a, 1b, 1c, 1d, 1e) aufgelegt werden und zumindest bereichsweise an seitlichen Stirnseiten der Saatsubstrate (2) die stoffliche Verbindung (3) mit dem Trägerelement (1, 1a, 1b, 1c, 1d, 1e) ausgebildet wird, und wobei ein Saatsubstrat (2) mittels der stofflichen Verbindung (3) mit dem Trägerelement (1, 1a, 1b, 1c, 1d, 1e) und mit einem benachbarten Saatsubstrat (2) verbunden wird.

2. Verfahren nach Anspruch 1,
**dadurch gekennzeichnet,**
**dass** die Saatsubstrate (2) eine Dotierung des n- oder p-Typs aufweisen und dass die stoffliche Verbindung (3) eine Dotierung des entgegengesetzten Dotierungstyps aufweist.

3. Verfahren nach einem der vorangegangenen Ansprüche,
**dadurch gekennzeichnet,**
**dass** die stoffliche Verbindung (3) durch CVD-Abscheidung, insbesondere eine epitaktische Abscheidung ausgebildet wird.

4. Verfahren nach einem vorangegangenen Ansprüche,
**dadurch gekennzeichnet,**
**dass** vor Ausbilden der stofflichen Verbindung zwischen Saatsubstrat (2) und Trägerelement (1, 1a, 1b, 1c, 1d, 1e) die dem Trägerelement (1, 1a, 1b, 1c, 1d, 1e) abgewandte Seite der Saatsubstrate (2) vorbehandelt, insbesondere porosifiziert wird und/oder mit einer Deckschicht versehen wird.

5. Verfahren nach einem der vorangegangenen Ansprüche,
**dadurch gekennzeichnet,**
**dass** auf die an dem Trägerelement (1, 1a, 1b, 1c, 1d, 1e) angeordneten Saatsubstrate (2) zumindest eine Halbleiterschicht (6) abgeschieden wird, insbesondere epitaktisch abgeschieden wird,
und **dass** die Halbleiterschicht (6) von den Saatsubstraten (2) abgelöst wird, ohne die stoffliche Verbindung (3) zwischen Saatsubstrat (2) und Trägerelement (1, 1a, 1b, 1c, 1d, 1e) zu trennen.

6. Verfahren nach Anspruch 4,
**dadurch gekennzeichnet,**
**dass** eine Siliziumschicht auf die Saatsubstrate (2) abgeschieden wird, insbesondere mit einer Dicke im Bereich 20 µm bis 500 µm, bevorzugt im Bereich 30 µm bis 300 µm, insbesondere bevorzugt epitaktisch abgeschieden wird.

7. Verfahren nach einem der vorangegangenen Ansprüche,
**dadurch gekennzeichnet,**
**dass** die dem Trägerelement (1, 1a, 1b, 1c, 1d, 1e) abgewandte Seite der an dem Trägerelement (1, 1a, 1b, 1c, 1d, 1e) angeordneten Saatsubstrate (2) für eine Abscheidung einer Halbleiterschicht (6), insbesondere eine epitaktische Abscheidung, vorbehandelt wird, insbesondere porosifiziert wird, ohne die stoffliche Verbindung (3) zwischen Saatsubstrat (2) und Trägerelement (1, 1a, 1b, 1c, 1d, 1e) zu trennen.

8. Verfahren nach einem der vorangegangenen Ansprüche,
**dadurch gekennzeichnet,**
**dass** die Saatsubstrate (2) mittels stofflicher Verbindung (3) an dem Trägerelement (1, 1a, 1b, 1c, 1d, 1e) angeordnet werden und ohne die stoffliche Verbindung (3) zwischen Saatsubstrat (2) und Trägerelement (1, 1a, 1b, 1c, 1d, 1e) zu trennen mehrfach die Prozessabfolge
- Vorbehandeln der dem Trägerelement (1, 1a, 1b, 1c, 1d, 1e) abgewandten Seite der Saatsubstrate (2),
- Aufbringen zumindest einer Halbleiterschicht (6) auf die Saatsubstrate (2),
- Ablösen der Halbleiterschicht (6) von den Saatsubstraten (2) mit oder ohne Zwischenschaltung von weiteren Zwischenschritten durchgeführt wird, insbesondere zumindest 20 Mal, bevorzugt zumindest 50 Mal durchgeführt wird.

9. Verfahren nach einem der vorangegangenen Ansprüche,
**dadurch gekennzeichnet,**
**dass** auf jedes Saatsubstrat (2) jeweils eine Halbleiterschicht (6) aufgebracht wird und/oder
**dass** die Halbleiterschichten (6) zweier benachbarter Saatsubstrate (2) miteinander verbunden sind, insbesondere eine gemeinsame Halbleiterschicht (6) ausbilden,
vorzugsweise, dass zwischen zwei benachbarten Saatsubstraten (2) die stoffliche Verbindung (3) angeordnet wird und dass an der dem Trägerelement (1, 1a, 1b, 1c, 1d, 1e) abgewandten Seite die stoffliche Verbindung (3) mit den angrenzenden Saatsubstraten (2) mit einer ebenen Oberfläche ausgebildet werden.

10. Verfahren nach einem der vorangegangenen Ansprüche,
**dadurch gekennzeichnet,**
**dass** auf die an dem Trägerelement (1, 1a, 1b, 1c, 1d, 1e) angeordneten Saatsubstrate (2) zumindest eine Halbleiterschicht (6) aufgebracht wird und vor Ablösen der Halbleiterschicht (6) ein Trennschnitt (B) im Bereich zwischen benachbarten Saatsubstraten (2) erfolgt, insbesondere ein Trennschnitt (B) der zumindest die aufgebrachte Halbleiterschicht (6) durchdringt.

11. Verfahren nach einem der vorangegangenen Ansprüche,
**dadurch gekennzeichnet,**
**dass** die Saatsubstrate (2) zumindest an der dem Trägerelement (1, 1a, 1b, 1c, 1d, 1e) zugewandten Seite mittels stofflicher Verbindung (3) mit dem Trägerelement (1, 1a, 1b, 1c, 1d, 1e) verbunden werden, insbesondere, dass die Saatsubstrate (2) an dem Trägerelement (1, 1a, 1b, 1c, 1d, 1e) angeordnet werden und mittels zumindest einer, bevorzugt mehrerer Öffnungen im Trägerelement (1, 1a, 1b, 1c, 1d, 1e) Material zur stofflichen Verbindung (3) zwischen Saatsubstrat (2) und Trägerelement (1, 1a, 1b, 1c, 1d, 1e) eingebracht wird.

12. Verfahren nach einem der vorangegangenen Ansprüche,
**dadurch gekennzeichnet,**
**dass** an zwei gegenüberliegenden Seiten des Trägerelements (1, 1a, 1b, 1c, 1d, 1e) Saatsubstrate (2) mittels stofflicher Verbindung (3) angeordnet werden.

13. Trägerelement (1, 1a, 1b, 1c, 1d, 1e) mit Saatsubstraten (2) zur Beschichtung mit einer Halbleiterschicht (6),
wobei die Saatsubstrate (2) an dem Trägerelement (1, 1a, 1b, 1c, 1d, 1e) angeordnet sind,
**dadurch gekennzeichnet,**
**dass** die Saatsubstrate (2) auf das Trägerelement (1, 1a, 1b, 1c, 1d, 1e) aufgelegt und mittels stofflicher Verbindung (3) an dem Trägerelement (1, 1a, 1b, 1c, 1d, 1e) angeordnet sind, wobei die stoffliche Verbindung (3) zwischen Saatsubstrat (2) und Trägerelement (1, 1a, 1b, 1c, 1d, 1e) ein Halbleitermaterial umfassend ausgebildet ist, welches zur Ausbildung der Halbleiterschicht (6) verwendet wird, wobei die Saatsubstrate (2) auf eine Oberfläche des Trägerelements (1, 1a, 1b, 1c, 1d, 1e) aufgelegt sind und zumindest bereichsweise an seitlichen Stirnseiten der Saatsubstrate (2) die stoffliche Verbindung (3) mit dem Trägerelement (1, 1a, 1b, 1c, 1d, 1e) ausgebildet ist, und wobei ein Saatsubstrat (2) mittels der stofflichen Verbindung (3) mit dem Trägerelement (1, 1a, 1b, 1c, 1d, 1e) und mit einem benachbarten Saatsubstrat (2) verbunden ist.

14. Trägerelement (1, 1a, 1b, 1c, 1d, 1e) nach Anspruch 13,
**dadurch gekennzeichnet,**
**dass** das Trägerelement (1, 1a, 1b, 1c, 1d, 1e) zumindest eine Auflage für jedes Saatsubstrat (2) aufweist, an welchen eine dem Trägerelement (1, 1a, 1b, 1c, 1d, 1e) zugewandte Rückseite des Saatsubstrates (2) unmittelbar an dem Trägerelement anliegt und dass das Trägerelement (1, 1a, 1b, 1c, 1d, 1e) im Randbereich jedes Saatsubstrats (2) zumindest eine Vertiefung, bevorzugt ein um den Rand des Saatsubstrats (2) umlaufende Vertiefung aufweist, an welcher die Rückseite des Saatsubstrats (2) stoffschlüssig mit dem Träger verbunden ist.

## Claims

1. Method for arranging a plurality of semiconductor seed substrates (2) on a carrier element (1, 1a, 1b, 1c, 1d, 1e) for application of a semiconductor layer (6) to the seed substrates (2),
wherein the seed substrates (2) are placed on the carrier element (1, 1a, 1b, 1c, 1d, 1e) and arranged on the carrier element (1, 1a, 1b, 1c, 1d, 1e) by means of bonding connection (3), the bonding connection (3) between seed substrate (2) and carrier element (1, 1a, 1b, 1c, 1d, 1e) comprising a semiconductor material that is used for forming the semiconductor layer (6), wherein the seed substrates (2) are placed on a surface of the carrier element (1, 1a, 1b, 1c, 1d, 1e) and the bonding connection (3) with the carrier element (1, 1a, 1b, 1c, 1d, 1e) is formed at least in some regions on lateral end faces of the seed substrates (2), and wherein a seed substrate (2) is joined to the carrier element (1, 1a, 1b, 1c, 1d, 1e) and to an adjacent seed substrate (2) by means of the bonding connection (3).

2. Method according to claim 1,
**characterised in that**
the seed substrates (2) have n-type or p-type doping; and the bonding connection (3) has doping of the opposite doping type.

3. Method according to either one of the preceding claims,
**characterised in that**
the bonding connection (3) is formed by chemical vapour deposition, especially epitaxial deposition.

4. Method according to any one of the preceding claims,
**characterised in that**
before the bonding connection between seed substrate (2) and carrier element (1, 1a, 1b, 1c, 1d, 1e) is formed, the side of the seed substrates (2) facing away from the carrier element (1, 1a, 1b, 1c, 1d, 1e) is pretreated, especially subjected to porosification, and/or is provided with a cover layer.

5. Method according to any one of the preceding claims, **characterised in that**
at least one semiconductor layer (6) is deposited, especially epitaxially deposited, on the seed substrates (2) arranged on the carrier element (1, 1a, 1b, 1c, 1d, 1e);
and the semiconductor layer (6) is detached from the seed substrates (2) without the bonding connection (3) between seed substrate (2) and carrier element (1, 1a, 1b, 1c, 1d, 1e) being severed.

6. Method according to claim 4,
**characterised in that**
a silicon layer is deposited on the seed substrates (2), especially having a thickness in the range of 20 µm to 500 µm, preferably in the range of 30 µm to 300 µm, especially preferably being epitaxially deposited.

7. Method according to any one of the preceding claims,
**characterised in that**
the seed substrates (2) arranged on the carrier element (1, 1a, 1b, 1c, 1d, 1e) are pretreated, especially subjected to porosification, on the side facing away from the carrier element (1, 1a, 1b, 1c, 1d, 1e) for deposition of a semiconductor layer (6), especially epitaxial deposition, without the bonding connection (3) between seed substrate (2) and carrier element (1, 1a, 1b, 1c, 1d, 1e) being severed.

8. Method according to any one of the preceding claims,
**characterised in that**
the seed substrates (2) are arranged on the carrier element (1, 1a, 1b, 1c, 1d, 1e) by means of bonding connection (3) and, without the bonding connection (3) between seed substrate (2) and carrier element (1, 1a, 1b, 1c, 1d, 1e) being severed, the process sequence
- pretreatment of the side of the seed substrates (2) that faces away from the carrier element (1, 1a, 1b, 1c, 1d, 1e),
- application of at least one semiconductor layer (6) to the seed substrates (2),
- detachment of the semiconductor layer (6) from the seed substrates (2),
is carried out repeatedly, with or without interposition of further intermediate steps, especially at least 20 times, preferably at least 50 times.

9. Method according to any one of the preceding claims, **characterised in that**
a semiconductor layer (6) is applied to each seed substrate (2); and/or
the semiconductor layers (6) of two adjacent seed substrates (2) are joined to one another, especially forming a common semiconductor layer (6);
preferably, the bonding connection (3) is arranged between two adjacent seed substrates (2); and the bonding connection (3) together with the adjoining seed substrates (2) is provided with a flat surface on the side facing away from the carrier element (1, 1a, 1b, 1c, 1d, 1e).

10. Method according to any one of the preceding claims,
**characterised in that**
at least one semiconductor layer (6) is applied to the seed substrates (2) arranged on the carrier element (1, 1a, 1b, 1c, 1d, 1e) and, before detachment of the semiconductor layer (6), a separating cut (B) is made in the region between adjacent seed substrates (2), especially a separating cut (B) which penetrates at least the applied semiconductor layer (6).

11. Method according to any one of the preceding claims,
**characterised in that**
the seed substrates (2), at least on the side facing towards the carrier element (1, 1a, 1b, 1c, 1d, 1e), are joined to the carrier element (1, 1a, 1b, 1c, 1d, 1e) by means of bonding connection (3);
especially, the seed substrates (2) are arranged on the carrier element (1, 1a, 1b, 1c, 1d, 1e) and material for the bonding connection (3) between seed substrate (2) and carrier element (1, 1a, 1b, 1c, 1d, 1e) is introduced by means of at least one opening, preferably a plurality of openings, in the carrier element (1, 1a, 1b, 1c, 1d, 1e).

12. Method according to any one of the preceding claims,
**characterised in that**
seed substrates (2) are arranged on two opposite sides of the carrier element (1, 1a, 1b, 1c, 1d, 1e) by means of bonding connection (3).

13. Carrier element (1, 1a, 1b, 1c, 1d, 1e) having seed substrates (2) for coating with a semiconductor layer (6),
wherein the seed substrates (2) are arranged on the carrier element (1, 1a, 1b, 1c, 1d, 1e),
**characterised in that**
the seed substrates (2) have been placed on the carrier element (1, 1a, 1b, 1c, 1d, 1e) and arranged on the carrier element (1, 1a, 1b, 1c, 1d, 1e) by means of bonding connection (3), the bonding connection (3) between seed substrate (2) and carrier element (1, 1a, 1b, 1c, 1d, 1e) comprising a semiconductor material that is used for forming the semiconductor layer (6), wherein the seed substrates (2) have been placed on a surface of the carrier element (1, 1a, 1b, 1c, 1d, 1e), and the bonding connection (3) with the carrier element (1, 1a, 1b, 1c, 1d, 1e) has been formed at least in some regions on lateral end faces of the seed substrates (2), and wherein a seed substrate (2) has been joined to the carrier element (1, 1a, 1b, 1c, 1d, 1e) and to an adjacent seed substrate (2) by means of the bonding connection (3).

14. Carrier element (1, 1a, 1b, 1c, 1d, 1e) according to claim 13,
**characterised in that**
the carrier element (1, 1a, 1b, 1c, 1d, 1e) has for each seed substrate (2) at least one support at which a rear side of the seed substrate (2) that faces towards the carrier element (1, 1a, 1b, 1c, 1d, 1e) is in direct contact with the carrier element; and the carrier element (1, 1a, 1b, 1c, 1d, 1e) has, in the edge region of each seed substrate (2), at least one depression, preferably a depression running around the edge of the seed substrate (2), at which the rear side of the seed substrate (2) has been bonded to the carrier.

## Revendications

1. Procédé pour disposer plusieurs substrats de germination (2) de semi-conducteur sur un élément de support (1, la, 1b, le, 1d, le), pour appliquer une couche de semi-conducteur (6) sur les substrats de germination (2),
dans lequel les substrats de germination (2) sont posés sur l'élément de support (1, la, 1b, le, 1d, le) et disposés sur l'élément de support (1, la, 1b, le, 1d, le) au moyen d'une liaison matérielle (3), dans lequel la liaison matérielle (3) entre le substrat de germination (2) et l'élément de support (1, la, 1b, le, 1d, le) est réalisée de manière à comprendre un matériau semi-conducteur, lequel est utilisé pour la réalisation de la couche de semi-conducteur (6), dans lequel les substrats de germination (2) sont posés sur une surface de l'élément de support (1, la, 1b, le, 1d, le) et la liaison matérielle (3) avec l'élément de support (1, la, 1b, le, 1d, le) est réalisée au moins par zones sur les faces frontales latérales des substrats de germination (2), et dans lequel un substrat de germination (2) est relié à l'élément de support (1, la, 1b, le, 1d, le) et à un substrat de germination (2) voisin au moyen de la liaison matérielle (3).

2. Procédé selon la revendication 1,
**caractérisé en ce que**
les substrats de germination (2) présentent un dopage du type n ou p et que la liaison matérielle (3) présente un dopage du type de dopage opposé.

3. Procédé selon l'une des revendications précédentes,
**caractérisé en ce que**
la liaison matérielle (3) est réalisée par dépôt physique en phase vapeur, en particulier un dépôt par épitaxie.

4. Procédé selon l'une des revendications précédentes,
**caractérisé en ce que**
avant la réalisation de la liaison matérielle entre le substrat de germination (2) et l'élément de support (1, 1a, 1b, 1c, 1d, 1e), la face des substrats de germination (2) opposée à l'élément de support (1, la, 1b, le, 1d, le) est prétraitée, en particulier rendue poreuse et/ou pourvue d'une couche de recouvrement.

5. Procédé selon l'une des revendications précédentes,
**caractérisé en ce que**
au moins une couche de semi-conducteur (6) est déposée sur les substrats de germination (2) disposés sur l'élément de support (1, 1a, 1b, 1e, 1d, 1e), en particulier est déposée par épitaxie,
et que la couche semi-conductrice (6) est détachée des substrats de germination (2), sans rompre la liaison matérielle (3) entre le substrat de germination (2) et l'élément de support (1, 1a, 1b, 1c, 1d, 1e).

6. Procédé selon la revendication 4,
**caractérisé en ce que**
une couche de silicium est déposée sur les substrats de germination (2), en particulier avec une épaisseur dans la plage de 20 µm à 500 µm, de préférence dans la plage de 30 µm à 300 µm, de manière particulièrement préférée par épitaxie.

7. Procédé selon l'une des revendications précédentes,
**caractérisé en ce que**
la face opposée à l'élément de support (1, la, 1b, le, 1d, le) des substrats de germination (2) disposés sur l'élément de support (1, 1a, 1b, 1c, 1d, 1e) est prétraitée pour un dépôt d'une couche de semi-conducteur (6), en particulier un dépôt épitaxique, en particulier est rendue poreuse, sans rompre la liaison matérielle (3) entre le substrat de germination (2) et l'élément de support (1, 1a, 1b, 1c, 1d, 1e).

8. Procédé selon l'une des revendications précédentes,
**caractérisé en ce que**
les substrats de germination (2) sont disposés sur l'élément de support (1, 1a, 1b, 1e, 1d, 1e) au moyen d'une liaison matérielle (3) et sans rompre la liaison matérielle (3) entre le substrat de germination (2) et l'élément de support (1, 1a, 1b, 1c, 1d, 1e), la séquence de processus
- prétraiter la face des substrats de germination (2) opposée à l'élément de support (1, 1a, 1b, 1c, 1d, 1e),
- appliquer au moins une couche de semi-conducteur (6) sur les substrats de germination (2),
- détacher la couche de semi-conducteur (6) des substrats de germination (2)
est réalisée à plusieurs reprises avec ou sans interposition d'autres étapes intermédiaires, en particulier au moins 20 fois, de préférence au moins 50 fois.

9. Procédé selon l'une des revendications précédentes,
**caractérisé en ce que**
une couche de semi-conducteur (6) respective est appliquée sur chaque substrat de germination (2) et/ou
les couches de semi-conducteur (6) de deux substrats de germination (2) voisins sont reliées l'une à l'autre, en particulier réalisent une couche de semi-conducteur (6) commune,
de préférence, que la liaison matérielle (3) est disposée entre deux substrats de germination (2) voisins et que la liaison matérielle (3) avec les substrats de germination (2) adjacents avec une surface lisse sont réalisées sur la face opposée à l'élément de support (1, 1a, 1b, 1c, 1d, 1e).

10. Procédé selon l'une des revendications précédentes,
**caractérisé en ce que**
au moins une couche de semi-conducteur (6) est appliquée sur les substrats de germination (2) disposés sur l'élément de support (1, 1a, 1b, 1c, 1d, 1e) et une coupe de séparation (B) s'effectue dans la zone entre des substrats de germination (2) voisins avant le détachement de la couche de semi-conducteur (6), en particulier une coupe de séparation (B) qui traverse au moins la couche de semi-conducteur (6) appliquée.

11. Procédé selon l'une des revendications précédentes,
**caractérisé en ce que**
les substrats de germination (2) sont reliés à l'élément de support (1, 1a, 1b, 1c, 1d, 1e) au moins sur la face tournée vers l'élément de support (1, 1a, 1b, 1c, 1d, 1e) au moyen d'une liaison matérielle (3), en particulier que les substrats de germination (2) sont disposés sur l'élément de support (1, 1a, 1b, 1c, 1d, 1e) et un matériau pour la liaison matérielle (3) entre le substrat de germination (2) et l'élément de support (1, 1a, 1b, 1c, 1d, 1e) est introduit au moyen d'au moins une ouverture, de préférence plusieurs, dans l'élément de support (1, 1a, 1b, 1c, 1d, 1e).

12. Procédé selon l'une des revendications précédentes,
**caractérisé en ce que**
des substrats de germination (2) sont disposés au moyen de la liaison matérielle (3) sur deux faces opposées de l'élément de support (1, 1a, 1b, 1c, 1d, 1e).

13. Élément de support (1, 1a, 1b, 1c, 1d, 1e) comprenant des substrats de germination (2) pour le revêtement avec une couche de semi-conducteur (6),
dans lequel les substrats de germination (2) sont disposés sur l'élément de support (1, 1a, 1b, 1c, 1d, 1e),
**caractérisé en ce que**
les substrats de germination (2) sont posés sur l'élément de support (1, 1a, 1b, 1c, 1d, 1e) et disposés sur l'élément de support (1, 1a, 1b, 1c, 1d, 1e) au moyen d'une liaison matérielle (3), dans lequel la liaison matérielle (3) entre le substrat de germination (2) et l'élément de support (1, 1a, 1b, 1c, 1d, 1e) est réalisée de manière à comprendre un matériau semi-conducteur, lequel est utilisé pour la réalisation de la couche de semi-conducteur (6), dans lequel les substrats de germination (2) sont posés sur une surface de l'élément de support (1, 1a, 1b, 1c, 1d, 1e) et la liaison de matière (3) avec l'élément de support (1, 1a, 1b, 1c, 1d, 1e) est réalisée au moins par zones sur les faces frontales latérales des substrats de germination (2), et dans lequel un substrat de germination (2) est relié à l'élément de support (1, 1a, 1b, 1c, 1d, 1e) et à un substrat de germination (2) voisin au moyen de la liaison matérielle (3).

14. Élément de support (1, 1a, 1b, 1c, 1d, 1e) selon la revendication 13,
**caractérisé en ce que**
l'élément de support (1, 1a, 1b, 1c, 1d, 1e) présente au moins un appui pour chaque substrat de germination (2), sur lequel une face arrière du substrat de germination (2) tournée vers l'élément de support (1, 1a, 1b, 1c, 1d, 1e) s'applique directement sur l'élément de support et que l'élément de support (1, 1a, 1b, 1c, 1d, 1e) présente dans la zone de bord de chaque substrat de germination (2) au moins un évidement, de préférence un évidement faisant le tour du bord du substrat de germination (2), sur lequel la face arrière du substrat de germination (2) est reliée par liaison de matière au support.
